# EUROPÄISCHE PATENTANMELDUNG

(11) **EP 1 139 482 A2**
(43) Veröffentlichungstag der Anmeldung: **04.10.2001**
(21) Anmeldenummer: 01103179.6
(22) Anmeldetag: 10.02.2001
(51) Int. Cl.: H01M 10/48, H01M 2/10

(54) **Elektrischer Akkumulator mit elektronischer Sicherheitsschutzschaltung**

(30) Priorität: 29.03.2000 DE 20005816 U
(71) Anmelder: VARTA Gerätebatterie GmbH, 30419 Hannover (DE)
(72) Erfinder: Maybach, Michael, 73441 Bopfingen (DE); Knop, Ingmar, 73433 Aalen (DE); Ilic, Dejan, Dr., 73479 Ellwangen (DE); Vetter, Stefan, 73479 Ellwangen (DE)
(74) Vertreter: Kaiser, Dieter Ralf, Dipl.-Ing.

(57) **Zusammenfassung**

Ein elektrischer Akkumulator besitzt eine elektronische Sicherheitsschutzschaltung und einen mit dem Gehäuse des Akkumulators (1) in wärmeleitender Verbindung stehenden PTC-Widerstand (3), der durch Nieten oder Kleben mit der Leiterplatte (2) der elektronischen Schutzschaltung elektrisch verbunden ist, die durch Streifenableiter (5) mit dem Akkumulator in Verbindung steht.Die Leiterplatte (2) ist derart auf den Akkumulator (1) bzw. dessen Rand (1a) umgeklappt, dass ein wärmeleitender Kontakt zwischen Akkumulatorengehäuse (1) bzw. Rand des Akkumulatorengehäuses (1a) und PTC-Widerstand (3) hergestellt ist. Die elektronische Sicherheitsschutzschaltung ist mit Streifenableitern am Akkumulator durch Ultraschall-Schweißung verbunden.

## Beschreibung

Gegenstand der Erfindung ist ein elektrischer Akkumulator mit elektronischer Sicherheitsschutzschaltung und einem mit dem Gehäuse des Akkumulators in wärmeleitender Verbindung stehenden PTC-Widerstand.

In vielen Geräten wie im Mobiltelefon, tragbaren Computern, Videokameras werden Akkumulatoren mit hoher Energiedichte, beispielsweise NiMeH oder Li-lon-Akkumulatoren, insbesondere Li-Polymer-Akkumulatoren (Li-lon-Akkumulatoren mit Polymerelektrolyt) verwendet. Bei mobilen Geräten werden wegen der hohen erzielbaren Energiedichten insbesondere Lithium-Akkumulatoren mit Li-lon-Technologie verwendet. Alle verwendeten Akkumulatoren, insbesondere aber Lithium-lonen-Zellen, erfordern eine spezielle Ladetechnik und insbesondere eine Sicherheitselektronik, die Überladung und Tiefentladungen verhindert. Bei Li-lon-Zellen und Li-Polymer-Akkumulatoren werden spezielle elektronische Schutzschaltungen verwendet, die auf einer externen Platine angeordnet sind und die bei Fehlverhalten des Laders oder Geräts bei vorgegebenen Lade- und Entladeschlussspannungen abschalten und zusammen mit speziellen Sicherungen die Zelle vor unzulässigen Spannungsniveaus bzw. -strömen schützen und damit irreversible Elektrolytzersetzungen und Zellschädigungen sowie Überhitzung verhindern. Darüber hinaus sind derartige Zellen mit einem Polyswitch gekoppelt (PTC-Widerstand), der mit dem Zellengehäuse oder einem Teil des Zellengehäuses wärmeleitend in Verbindung steht. Über diesen Polyswitch wird bei zu starker Erwärmung des Akkumulators das Ladeverfahren abgebrochen oder bei zu großen Strömen oder Kurzschluss die weitere Stromzufuhr zum oder vom Akkumulator unterbrochen. Derartige Polyswitch-Elemente sind im allgemeinen am Akkumulatorengehäuse platziert und mit einem Zellenableiter verschweißt. Eine Verschweißung wird im allgemeinen aus dem Grunde gewählt, dass der Polyswitch durch den höheren Wärmetransfer bei einem Lötverfahren bereits eine Vorschädigung erhalten könnte.

Aufgabe der Erfindung ist es, eine Anordnung anzugeben, die es gestattet, den Polyswitch in einfacher Weise in die Vormontage der Sicherheitselektronik einzubinden und anschließend in Wärmekontakt mit dem zu überwachenden Akkumulator zu bringen.

Diese Aufgabe wird erfindungsgemäß bei dem eingangs genannten Akkumulator durch die Merkmale des Anspruchs 1 gelöst. Weitere Ausgestaltungen der Erfindung sind in den Unteransprüchen angegeben.

Im Folgenden ist der Gegenstand der Erfindung anhand der Figuren näher erläutert. Dabei zeigt Figur 1 schematisch die Platine der Sicherheitselektronik, Figur 2 eine Akkumulatorenzelle mit elektrisch damit verbundener Sicherheitselektronik und Figur 3 die gleiche Zelle, bei der der Polyswitch in wärmeleitenden Kontakt mit dem Akkumulator gebracht ist.

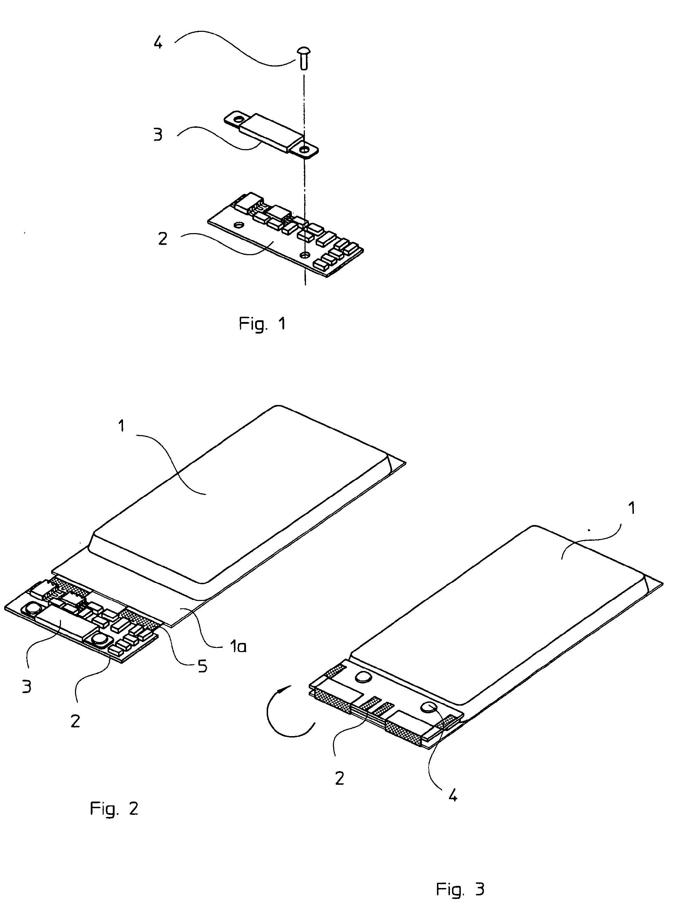

In Figur 1 ist schematisch die Sicherheitselektronik auf einer starren Leiterplatte 2 angeordnet. Mit dieser Leiterplatte ist erfindungsgemäß der Polyswitch bzw. PTC-Widerstand 3 durch ein einfaches Nietverfahren (Nieten 4) elektrisch leitend verbunden. Anstelle eines Nietverfahrens kann auch gegebenenfalls eine Klebung mittels leitfähigen Klebers vorgenommen werden. Durch diese Maßnahme wird eine Vorschädigung des PTC-Widerstandes, wie sie durch die Wärmeeintragung beim Löten erfolgen könnte, sicher vermieden.

Diese Leiterplatte 2 mit Polyswitch 3 ist mit dem Akkumulator 1, der Streifenableiter 5 besitzt, elektrisch verbunden, beispielsweise an den Kontaktstellen durch ein Ultraschall-Schweißverfahren. Gemäß Figur 3 ist die Leiterplatte 2 mit dem PTC-Widerstand auf den vorstehenden Rand 1a des Akkumulatorengehäuses 1 umgeklappt, so dass der Polyswitch in wärmeleitenden Kontakt mit dem Akkumulatorengehäuse bzw. mit dem Rand des Akkumulatorengehäuses gelangt. Der Akkumulator ist vorteilhafterweise ein Li-lon-Akkumulator oder Li-Polymer-Akkumulator in flacher prismatischer Bauweise, wobei eine Gehäusewandung einen über den Umfang des Akkumulators hinausragenden Rand 1a bildet, der als Wärmekontakt zum Polyswitch dient.

Die erfindungsgemäße Anordnung ermöglicht es, Batterie-Packs mit Lithium-lon-Zellen oder Li-Polymer-Zellen mit auf einer Platine angebrachter Sicherheitselektronik und einem Polyswitch einfach und kostengünstig herzustellen und ermöglicht darüber hinaus einen außerordentlich kompakten Aufbau des gesamten Batterie-Packs.

## Patentansprüche

1. Elektrischer Akkumulator mit elektronischer Sicherheitsschutzschaltung und einem mit dem Gehäuse des Akkumulators in wärmeleitender Verbindung stehenden PTC-Widerstand, **dadurch gekennzeichnet, dass** der PTC-Widerstand (3) durch Nieten oder Kleben mit der Leiterplatte (2) der elektronischen Schutzschaltung elektrisch verbunden ist, die durch Streifenableiter (5) mit dem Akkumulator in Verbindung steht, und **dass** die Leiterplatte (2) derart auf den Akkumulator (1) bzw. dessen Rand (1a) umgeklappt ist, **dass** ein wärmeleitender Kontakt zwischen Akkumulatorengehäuse (1) bzw. Rand des Akkumulatorengehäuses (1a) und PTC-Widerstand (3) hergestellt ist.

2. Elektrischer Akkumulator nach Anspruch 1, **dadurch gekennzeichnet, dass** die elektronische Sicherheitsschutzschaltung mit Streifenableitern am Akkumulator durch Ultraschall-Schweißung verbunden ist.

3. Elektrischer Akkumulator nach Anspruch 1, **dadurch gekennzeichnet, dass** er ein Li-lon-Akkumulator oder Li-Polymer-Akkumulator in flacher, prismatischer Bauweise ist.

4. Elektrischer Akkumulator nach einem der Ansprüche 1 bis 3, **dadurch gekennzeichnet, dass** das Gehäuse des Akkumulators einen vorstehenden Rand (1a) bildet, auf welchen die Sicherheitsschutzschaltung mit PTC-Widerstand (3) umgeklappt ist.
